Europäisches Patentamt

European Patent Office

Office européen des brevets

(19)

(11) **EP 0 714 099 A1**

(12) **EUROPEAN PATENT APPLICATION**

(43) Date of publication:
29.05.1996 Bulletin 1996/22

(51) Int. Cl.$^6$: **G11C 5/14**, G05F 3/20

(21) Application number: 94830543.8

(22) Date of filing: 24.11.1994

(84) Designated Contracting States:
DE FR GB IT

(71) Applicant: SGS-THOMSON MICROELECTRONICS S.r.l.
I-20041 Agrate Brianza (Milano) (IT)

(72) Inventors:
• Baldi, Livio
I-20041 Agrate Brianza (Milano) (IT)

• Ricco', Bruno
I-40126 Bologna (IT)

(74) Representative: Bottero, Claudio
c/o Porta, Checcacci & Botti S.r.l.
Viale Sabotino, 19/2
I-20135 Milano (IT)

(54) **CMOS semiconductor integrated circuit for a low power supply and having low power dissipation in stand-by**

(57) An electronic circuit (30) integrated on a semiconductor in CMOS technology, being powered at a low supply voltage and having reduced power dissipation while in the off state, of the type which comprises at least one MOS or CMOS electronic device (2,3) formed on a semiconductor substrate (4) with a predetermined threshold voltage value ($V_T$), comprises at least one electronic switch (12,17) for connection of the substrate (4) to at least two different bias voltage references. This switch is controlled by a turn-off command signal to change the substrate (4) bias in the rest condition, and hence the threshold voltage ($V_T$) of the device upon the latter being turned off.

FIG. - 1

EP 0 714 099 A1

## Description

Field of the Invention

This invention relates to an electronic circuit integrated on a semiconductor in CMOS technology, being supplied by a low supply voltage, having a reduced off state power dissipation, and comprising at least one MOS or CMOS electronic device formed on the semiconductor substrate with a predetermined threshold voltage value.

Specifically, but not exclusively, the invention relates to a circuit structure which is integrated monolithically by a sub-micrometric process, and the description which follows will make reference to this field of application for simplicity of illustration.

The invention also concerns a method of powering an electronic circuit monolithically integrated on a semiconductor, which is supplied by a low supply voltage and has a reduced off state power dissipation.

The inventive principle is also applicable, however, to a large class of electronic semiconductor circuits and components, ranging from simple MOS transistors to complex logic circuit networks, flip-flops, SRAMs, latches, interfaces, Arithmetic Logic Units (ALU), etc.

It is well recognized that a demand for reduced power consumption by the electronic components incorporated to an integrated circuit exists in the specific application field of this invention.

This demand is particularly stringent in connection with all those complex logic devices which are integrated in CMOS technology using sub-micrometric processes, e.g. processes below 0.5 μm.

In integrated circuits of high complexity, most of the logic blocks implemented in CMOS technology usually are only responsible for a negligible proportion of the power dissipated by the whole circuit because they are subjected to no switching.

However, this ceases to be true where circuits are involved which comprise transistors having low threshold voltages in modulo.

As an example, in relation to the threshold voltage values, the positive threshold voltage $V_{TN}$ of an N-channel MOS transistor may be 0.5 to 0.6 Volts if the circuit is supplied a voltage Vdd in excess of 3V. Otherwise, where the circuit is supplied by a lower voltage, namely about 1-1.2 V, the transistor threshold should not exceed 0.4 V.

Likewise, as regards the negative threshold voltage $-V_{TP}$ of P-channel MOS transistors, this should have values which depart substantially from those specified above in relation to N-channel transistors. Thus, for simplicity of illustration, reference will be made herein to a single threshold value designated $V_T = V_{TN} = -V_{TP}$, although this should not be construed as limitative of the considerations made hereinafter.

It matters to observe that, since transistors can be turned off using a sub-threshold voltage which is at most equal to their threshold voltage $V_T$, if the latter is not sufficiently high (in actual practice, at least higher than 0.4V), significant leakage currents $I_{SUB}$, also referred to as "sub-threshold" currents, may be incurred.

This basically involves the appearance of a current flow $I_{SUB}$ which also flows, from the supply voltage Vdd toward ground, through non-switching logic blocks which form the great majority of those provided in a CMOS circuit. This current is essentially controlled by the off state of the transistors, that is by their resistance in the off state, as well as by the amount of sub-threshold bias. Consequently, the leakage current will be dependent on the threshold voltage $V_T$ of the transistors.

In the worst cases, this current $I_{SUB}$ will substantially coincide with the "sub-threshold" current of a single transistor.

The presence of this leakage current is of no use from the standpoint of a properly operating circuit. On the contrary, it tends to downgrade the margin for immunity to noise, although this effect may not be a major one.

In integrated circuits of particular complexity, the outcome of this leakage current is mainly a significant contribution to power consumption, and it is well recognized that the problem of power consumption at rest is a highly important one, especially to all those portable battery-powered electronic apparatus for which the working phase spreads over a much shorter time period than their rest phase.

A typical example of an apparatus of this kind is the cellular phone, which is held in a standby condition for most of the time.

Background Art

In view of this problem, considerable effort is presently expended to develop technologies which can minimize, if not altogether suppress, the "sub-threshold" leakage current.

Within this context, it should be mentioned that this effort meets an opposition from the type of dependence which ties the "sub-threshold" current to the threshold current $V_T$. This is, in fact, an exponential type of dependence having an upper limit which involves a reduction by at least one order of magnitude in the current $I_{SUB}$ against an increase of 80 mV in sub-threshold bias, or ultimately, in the threshold value $V_T$. Specifically, a slope of about 80mV per decade is an ideal value for the sub-threshold curve, and in actual practice, values of 90 to 100 mV/decade are generally attained for N-channel transistors, and 100 to 120 mV/decade for P-channel transistors.

As a direct consequence to this, an apparently conflicting situation is to be faced between the need to have the threshold value reduced, in order to ensure high-performance from low-voltage powered transistors, and the need to have the threshold voltage increased, in order to drastically cut down the undesired "sub-threshold" current.

By way of example, if a threshold value of 0.3 to 0.4 V is assumed, such as would be acceptable for N-channel transistors being supplied up to 2.5 V (a rule of thumb provides for the threshold voltage to be one fifth of the supply voltage, for the transistor to operate properly), a corresponding current $I_{SUB}$ should be reasonably expected to lie in the 10 to 100 nA/μm range. Now, for an integrated circuit with a transistor population density of approximately 10 millions/cm$^2$, such a "sub-threshold" current, while being negligible compared to the switching current, would still result in a hardly admissible power dissipation while in the off condition.

As an attempt at obviating such drawbacks, a technical approach has been proposed as disclosed, for instance, in US Patent No. 4.797.899.

Described in that document is a charge pump circuit for converting a single-pole supply voltage into a pair of supply voltage values of wider scope. These voltage values are selectively applied to the substrate of a semiconductor electronic device to ensure appropriate start-up conditions for the device through the well-known "body effect".

That solution, however, teaches nothing about changing the threshold voltage value of the transistors in order to drastically reduce the leakage currents in the off state. Also, the problems brought about by the conflicting requirements of enhancing the transistor performance in the dynamic range and simultaneously reducing the sub-threshold leakage currents are not considered in said document.

Furthermore, the prior art has provided no solution to the problem of how can the threshold voltage of certain devices be raised selectively without causing other devices to become turned off which should be held in a conduction state.

The technical problem underlying this invention is to provide an electronic circuit integrated on a semiconductor in CMOS technology, which has such construction and performance features that its power dissipation in the off state can be drastically reduced, and in particular such that the conflicting demands related to the device threshold voltage, power consumption and dynamic range, can all be filled, thereby overcoming the limitations and drawbacks of current prior art embodiments.

## Summary of the Invention

The solutive idea according to this invention is based on the premise that it would be advantageous if different threshold voltages could be provided to suit the operational state of the transistors incorporated to the semiconductor circuit. When the transistors are conducting, e reduced threshold voltage would provide good performance in terms of switching speed, whereas in the off state of the transistors, a high threshold voltage would allow the undesired "sub-threshold" current to be minimized.

In other words, the solutive idea proposed by this invention provides for the transistors incorporated to the circuit to have a low threshold voltage as they operate to switch the logic gates, and a higher threshold voltage while the logic gates, or for that matter the whole integrated circuit, are in a rest condition.

Consistently with such considerations, the solutive idea provides an integrated circuit on a semiconductor substrate which has different substrate bias voltages according to its operational conditions. This is made feasible by that the threshold voltage of the transistors is changed by electric commands effective to alter the substrate bias according to the operational condition of the transistors.

Based on this solutive idea, the technical problem is solved by a CMOS integrated circuit of the type specified above and as defined in the characterizing portion of Claim 1 foll..

The technical problem is also solved by a method of powering an integrated circuit as defined in Claim 8 foll..

The technical problem is solved through the use of electronic switches which enable the bias of the semiconductor substrate, on which the transistor voltage is heavily dependent due to the well-known "body effect", to be changed.

This change in bias can selectively be applied even by selecting the transistors to be affected. In essence, one can either act on the integrated circuit as a whole or just a portion thereof; in addition, all MOS transistor types can be affected by the change or just one of them, that is either the N-channel or P-channel type.

The features and advantages of the device and method according to the invention will be apparent from the following detailed description of embodiments thereof, given by way of example and not of limitation with reference to the accompanying drawings.

## Brief Description of the Drawings

In the drawings:

- Figure 1 shows a schematic view, partly in vertical section and drawn to an enlarged scale, of a semiconductor electronic device operated in accordance with this invention;

- Figure 2 shows schematically a second embodiment of the inventive device;

- Figure 3 shows an equivalent electric circuit of the device in Figure 1;

- Figure 4 shows the circuit of Figure 3 in a different condition of its operation; and

- Figure 5 shows a schematic view of a semiconductor integrated circuit according to the invention.

Detailed Description

With reference to the drawing figures, and in particular to Figure 5, generally denoted by 30 is an electronic circuit which is integrated monolithically on a semiconductor substrate. The circuit 30 comprises a main structure which is implemented in either MOS or CMOS technology.

Associated with the CMOS structure is a first circuit portion, denoted by the acronym BBG (Body Bias Generator), and a second circuit portion C of switch control. This control portion C is connected to both the CMOS structure and the portion BBG, and receives an external standby signal.

All the components of the circuit 30 are powered in a manner known per se, it being possible for the CMOS portion to be supplied a particularly low voltage of less than 3V.

Advantageously, according to the invention, the portion BBG comprises a bias voltage generator which is connected directly to the semiconductor substrate of the circuit 30 to apply a predetermined voltage value to the latter according to the operational state of the transistors incorporated to the CMOS structure.

In particular, upon the logic gates incorporated to the CMOS structure being turned off, said predetermined voltage value is effective to increase the threshold voltage of all the transistors incorporated to the CMOS structure.

The semiconductor substrate biasing is controlled from the switch control portion C according to the standby signal. Alternatively, a suitable signal, generated within the circuit, may be used to trigger on the control circuit C. This signal could even be clocked and generated after a predetermined time period has elapsed when no change has occurrend at the inputs.

The bias voltage generator BBG can also be operated upon the threshold voltage of a reference transistor dropping below a predetermined value.

Advantageously, moreover, the generator BBG is operated at two different frequencies, a relatively high one for initial biasing, and a markedly lower holding frequency.

To make the invention aspects more clearly understood, a very simple case will now be considered wherein the integrated circuit comprises at least one MOS or CMOS component.

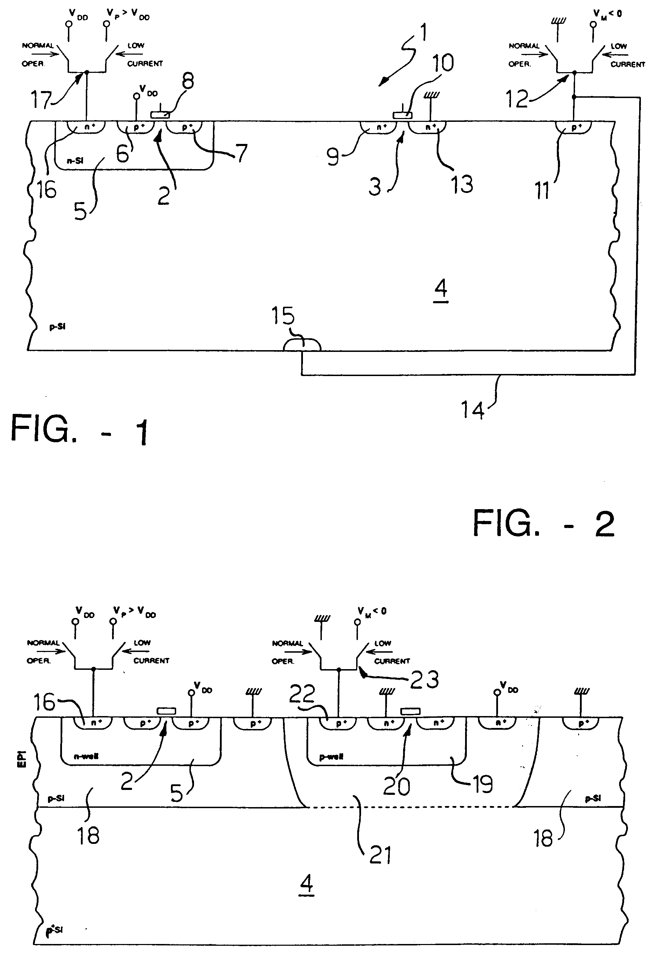

For example, with reference to Figure 1, generally and schematically shown at 1 is a semiconductor-integrated electronic device which is operated on this invention principle.

The device 1 is here an inverter comprising a so-called complementary pair of transistors, 2 and 3, implemented in CMOS technology. The invention would also apply, however, to any types of MOS technology devices.

Specifically in the example of Figure 1, such transistors 2 and 3 are formed on a semiconductor substrate 4 which has been slightly doped with a first type of dopant, e.g. of the P type.

The first transistor 2 is a P-channel MOS type, and is formed within an isolation N-type well, that is one being doped oppositely from the substrate 4.

Conventionally provided inside said well 5 are active source and drain areas, 6 and 7, defining a channel region therebetween which is overlaid by the so-called gate 8 of the transistor. The active areas 6 and 7 are doped with the first or P type of dopant at a higher concentration than the substrate 4 as denoted by P+. The source area 6 is connected to a reference supply voltage Vdd.

The second transistor 3 is an N-channel MOS type, and can be formed directly on the substrate 4 as shown in Figure 1. The drain and source active areas of this second transistor 3 are denoted by the numerals 9 and 13, respectively, and given a predetermined concentration of dopant of the N+ type. The source area 13 is connected to a second voltage reference, such as a signal ground potential.

Indicated at 10 is the gate of the second, N-channel transistor 3.

Advantageously, in accordance with the invention, the device 1 has a first contact 11 in the substrate 4. In the embodiment under consideration by way of non-limitative example, this contact 11 is formed with a surface region which is doped P+. In addition, an electric connection 14 is provided between the contact 11 and a further contact 15 located on the opposite surface of the semiconductor substrate.

The contact 11 allows the substrate 4 to be connected to a switch 12 whereby the substrate can be applied a predetermined value voltage.

Specifically, in accordance with the invention, the switch 12 is adapted to either connect the substrate 4 to a first, zero voltage reference such as the signal ground GND, or to a second voltage reference Vm below zero. In the former case, the substrate would be substantially connected to ground during normal operation of the N-channel transistor 3 in the conducting state.

In the latter case, the substrate 4 would be reverse biased when the transistor 3 is cut off. In this way, the value of the threshold voltage $V_{TN}$ of the transistor 3 is increased due to "body effect".

Thus, in a static condition, i.e. the off condition, the transistor threshold can be increased by suitably controlling the switch 12 without this involving any adverse effect on the electric operation of the device; rather, the important benefit of a drastic reduction in "sub-threshold" current is secured thereby.

Advantageously, the device 1 is provided with a second contact 16 within the well 5, laterally of the first transistor 2. This second contact 16 allows the well 5 to be connected to a second switch 17 through which the "body" of the transistor 2 can be applied a predetermined voltage value.

In particular, the second switch 16 is also adapted to connect the substrate, specifically the well 5, to a first reference voltage Vdd, e.g. the supply voltage, and a second reference voltage Vp, higher than the supply voltage. In the former case, the well 5 would substantially be connected to the supply Vdd during normal operation of the P-channel transistor 2 in the conducting state.

In the latter case, on the other hand, the well 5 would be reverse biased relative to the supply when the transistor 2 is cut off. In this way, the value of the threshold voltage $V_{TP}$ of the transistor 2 can be altered controllably according to the operational state of the transistor 2.

Understandably, some means would have to be arranged for controlling the switches 12 and 17, which means has not been shown in the drawings because known per se, and could comprise BBG (Body Bias Generator) structures and/or so-called pass-transistors which allow the operations for switching the voltage level applied to the transistor bodies to be carried out in a quick and effective manner.

The circuit area increase involved in accommodating the BBGs or pass-transistors is a modest one indeed, being typically less than 1% of the overall area occupied by the integrated circuit. Further, the current consumption of a BBG voltage generator can be reduced by methods which are known per se.

Of course, a critical aspect is bound to be the switch-over timing. In fact, with apparatus which are left in a standby state for long time periods, relatively long switching times on the order of one microsecond can be acceptable.

Considering, as an example, a circuit of 1 cm$^2$ having an active area which accounts for about 20% of the overall circuit area, the total capacitance to be charged in switching the substrate potential from one state to the other of the two values provided would be in the 0.4 to 0.6 pF/$\mu$m$^2$ range. Even where this capacitance value is doubled, to account for other contributions, a value in the 2 to about $5 \times 10^{-8}$F is arrived at.

With a body bias of about one volt being switched between the two values contemplated, the overall charge required would be of 20 to 50 nC, which when related to a "sub-threshold" current of 10 mA, leads to conclude that switching at higher frequencies than 100 kHz would not be very efficient. Of course, the current required to hold the substrate bias, and corresponding junction leakage, would be much lower than the sub-threshold current.

Accordingly, when applied to integrated circuits of considerably large area, the technique described hereinabove would only pay with devices having comparatively long standby periods.

In this respect, assuming a switching time of one microsecond for turning the device on again, the overall current to be handled during the turn-on phase would be of 20 to 50 mA, and assuming, with good margin, a drive current of at least 200 $\mu$A/$\mu$m, a transistor with a width of 100 or 200 $\mu$m and minimal length would be adequate for a whole integrated circuit, and involve but a negligible increase in area.

Of course, the switch could be implemented using, rather than a single large transistor, a plurality of smaller size devices; this would allow the inventive principle to be applied to selected portions of the circuit rather than the circuit as a whole.

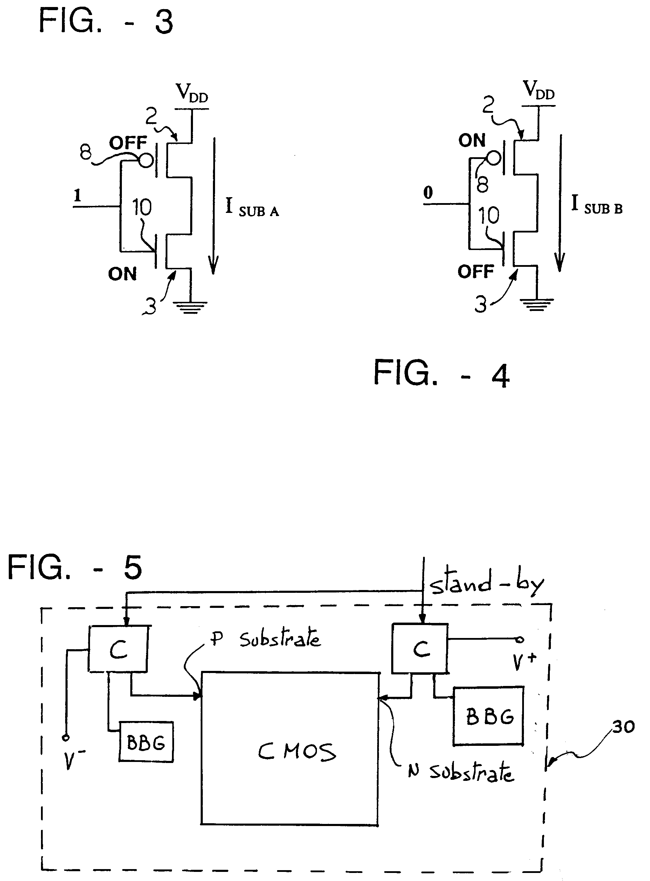

A second embodiment of the inventive device will now be described with particular reference to Figure 2, where the parts already described in connection with the previous embodiment carry the same reference numerals.

Shown in Figure 2 is a CMOS structure having active components formed in a P-doped epitaxial layer 18 which is deposited over the substrate 4 of the P+ type.

A first, P-channel MOS transistor 2 is formed in an N-well 5, as in the previous instance. Formed within the well 5 is a contact 16 for reverse biasing the "body" of the transistor 2 while this is held in an off state.

A second transistor 20 of the N-channel MOS type, is formed within a P-well 19. The well 19 is, in turn, accommodated in an isolation region 21 doped with a different dopant, e.g. of the N type.

The well 19 is also provided aith a contact 22 for reverse biasing the "body" of the transistor 20 while this is in the off state through a switch 23.

In essence, the example proposed in Figure 2 illustrates a CMOS technology whereby the substrates of both transistor types (N-channel and P-channel) can be biased independently of each other. In this case, the threshold voltage of each of them can be increased selectively according to necessity. For this purpose, it will be sufficient that the circuit implementation allows for each respective substrate type to be biased individually and independently.

Reverting now to the instance of the complementary pair of Figure 1, where the substrate of the N-channel transistors is common to the whole integrated circuit, it matters to notice that the biasing may here too affect, for simplicity, just one of the transistors 2 and 3 in the pair.

From this standpoint, Figures 3 and 4 are of assistance to a better understanding of the problem to be addressed in this case.

Both Figures show an equivalent wiring diagram for a CMOS inverter. The complementary pair of the MOS transistors 2 and 3 is connected between a reference node at a supply voltage Vdd and ground GND.

Both gates 8 and 10 of the transistors 2 and 3 are connected together and applied an electric signal at a logic high, i.e. a corresponding value to a logic "1".

Under this condition, the second transistor 3, of the N-channel MOS type, is conducting, whereas the first transistor 2, of the P-channel MOS type, is cut off and has a sub-threshold current $I_{SUBA}$ flowed therethrough. Based on the foregoing explanations, this current can be reduced by increasing the threshold voltage $V_{TP}$ of this transistor in absolute value.

However, if only transistors of a single type (the P-channel ones in the present embodiment) are affected, Figure 4 shows that in an opposite operational state from the previous one, whereby the transistor gates are supplied a signal at a logic low (logic "0"), substantially no reduction occurs in the "sub-threshold" current $I_{SUBB}$ compared to the instance where no substrate bias switching takes place. The current at rest would be cut down by one half even in the instance of one transistor type only being biased.

In fact, assuming that only the threshold of the, presently conducting, P-channel transistor 2 has been raised, the second N-channel transistor 3, presently in the off state, would have a "sub-threshold" current flowed therethrough which is significant in terms of power dissipation, and this because of the excessively low value that the threshold must have in order to optimize the dynamic range of the circuit.

Thus, for a most effective application of this invention, it is advisable that a control be provided for the threshold voltage of both transistors in the complementary pair as discussed in connection with Figure 1.

Where, on the other hand, the principle of this invention is to be applied to just one of the CMOS components, minor circuit modifications could be provided, such as the connection of switchable threshold transistors in series with the main circuit.

It will be apparent from the foregoing description that the device and method of this invention do solve the technical problem in a uniquely effective manner, while avoiding the need for radical changes to the structure of the CMOS devices to which this invention is applied.

In prior art MOS or CMOS circuits, each transistor has its substrate biased to a fixed, unvarying potential regardless of the operational state of that transistor.

This means that the threshold voltage of conventional transistors is set by compromising during the technological process between the need for good dynamic range (low threshold proportioned to the supply) and that for a reduced power consumption (relatively high threshold).

The invention has a major advantage in that it allows these limitations to be overcome by a selective change of the substrate bias in the circuits to which the transistors are incorporated.

The great flexibility afforded in the choices to be made in this direction enables the method of this invention to be adjusted for different circuit requirements.

Also, of great significance is the fact that increasing the bias voltage of the substrate in the rest condition is effective to hold the logic states within the circuit.

Worth mentioning is that the invention can be usefully applied to devices of an analog type which often require low threshold voltages and, therefore, are highly sensitive to "sub-threshold" currents, although in the instance of analog applications, both N-channel and P-channel transistor types may not be of necessity low threshold voltage ones.

**Claims**

1. An electronic circuit (30) integrated on a semiconductor in CMOS technology, being supplied by a low supply voltage and having a off state reduced power dissipation, of the type which comprises at least one MOS or CMOS electronic device (2,3) formed on a semiconductor substrate (4) with a predetermined threshold voltage value ($V_T$), characterized in that it comprises at least one electronic switch (12,17) for connection among the substrate (4) to at least two different bias voltage references, said switch being controlled by a turn-off command signal to change the substrate (4) bias in the rest condition and the threshold voltage ($V_T$) of the device upon the latter being turned off.

2. A circuit according to Claim 1, characterized in that said device is an N-channel MOS transistor (3) connected to the switch (12) through a contact (11) provided in the semiconductor substrate (4).

3. A circuit according to Claim 1, characterized in that said device is a P-channel MOS transistor (2) connected to the switch through a contact (16) provided in an isolation well (5) formed in the substrate (4) and accommodating said transistor (2).

4. A circuit according to Claim 1, characterized in that said device is a CMOS complementary structure of an N-channel and a P-channel transistor (2,3).

5. A circuit according to Claim 4, characterized in that only one of the transistors (2,3) forming said complementary pair is connected to said switch.

6. A circuit according to Claim 1, characterized in that it comprises a bias voltage generator (BBG) connected to the substrate (4) and a switch control circuit portion (C) connected between said at least one CMOS device and said generator, said portion (C) being controlled by the turn-off command signal.

7. A circuit according to Claim 6, characterized in that said bias voltage generator (BBG) is operated at at least two different frequencies.

8. A method of powering an electronic circuit monolithically integrated on a semiconductor, being supplied by a low supply voltage and having a off state reduced power dissipation, said circuit (30) comprising at least one MOS or CMOS structure (2,3) formed on the semiconductor substrate (4) and incorporating devices with a predetermined threshold voltage value ($V_T$), characterized in that it provides for electronically switching the bias voltage value applied to the substrate (4) upon certain of said devices being turned off and under control by a turn-off command signal.

9. A method according to Claim 8, characterized in that the substrate bias switching only affects the turned-off MOS transistors.

**10.** A method according to Claim 8, characterized in that it provides for the integration of a switch control circuit portion (C) controlled by said command signal.

FIG. - 1

FIG. - 2

# FIG. - 3

# FIG. - 4

# FIG. - 5

**European Patent Office**

## EUROPEAN SEARCH REPORT

Application Number

EP 94 83 0543

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP-A-0 564 204 (MITSUBISHI) <br> * column 1, line 34 - column 8, line 32 * <br> * column 14, line 11 - column 15, line 2; figures 1,9-11 * <br> --- | 1-10 | G11C5/14 <br> G05F3/20 |
| A | US-A-4 710 647 (YOUNG IAN) 1 December 1987 <br> * column 2, line 35 - line 60; figures * <br> --- | 1-10 | |
| A | DE-A-36 43 546 (MITSUBISHI ELECTRIC CORP) 25 June 1987 <br> * the whole document * <br> --- | 1,8 | |
| D,A | US-A-4 797 899 (FULLER ROGER W ET AL) 10 January 1989 <br> * the whole document * <br> ----- | | |
| | | | **TECHNICAL FIELDS SEARCHED (Int.Cl.6)** <br><br> G11C <br> G05F |

The present search report has been drawn up for all claims

| Place of search | Date of completion of the search | Examiner |
|---|---|---|
| BERLIN | 11 May 1995 | Roussel, A |